# FASCICULE DE BREVET EUROPEEN

(11) **EP 1 675 184 B1**
(45) Date de publication et mention de la délivrance du brevet: **13.08.2008**
(21) Numéro de dépôt: 05112805.6
(22) Date de dépôt: 22.12.2005
(51) Int. Cl.: H01L 29/872

(54) **Diode Schottky à barrière verticale**
Schottkydiode mit vertikaler Barriere
Schottky diode with vertical barrier

(30) Priorité: 23.12.2004 FR 0453183
(43) Date de publication de la demande: 28.06.2006
(73) Titulaire: ST MICROELECTRONICS S.A., 92120 Montrouge (FR)
(72) Inventeur: Lanois, Frédéric, 37100, Tours (FR); Nizou, Sylvain, 37210, Vernou sur Brenne (FR)
(74) Mandataire: de Beaumont, Michel

(56) Documents cités:
- EP-A- 0 271 346
- WO-A-03/096433
- WO-A-20/05057660
- US-A- 4 482 907
- US-A- 5 285 090
- KUMAR M J ET AL: "A NEW, HIGH-VOLTAGE 4H-SIC LATERAL DUAL SIDEWALL SCHOTTKY (LDSS) RECTIFIER: THEORETICAL INVESTIGATION AND ANALYSIS" IEEE TRANSACTIONS ON ELECTRON DEVICES, IEEE INC. NEW YORK, US, vol. 50, no. 7, juillet 2003 (2003-07), pages 1690-1693, XP001168267 ISSN: 0018-9383

## Description

### Domaine de l'invention

La présente invention concerne la fabrication de diodes Schottky, et notamment de diodes Schottky de moyenne puissance, susceptibles de laisser passer un courant direct avec une faible chute de tension, et de supporter des tensions inverses élevées avec un faible courant de fuite.

### Exposé de l'art antérieur

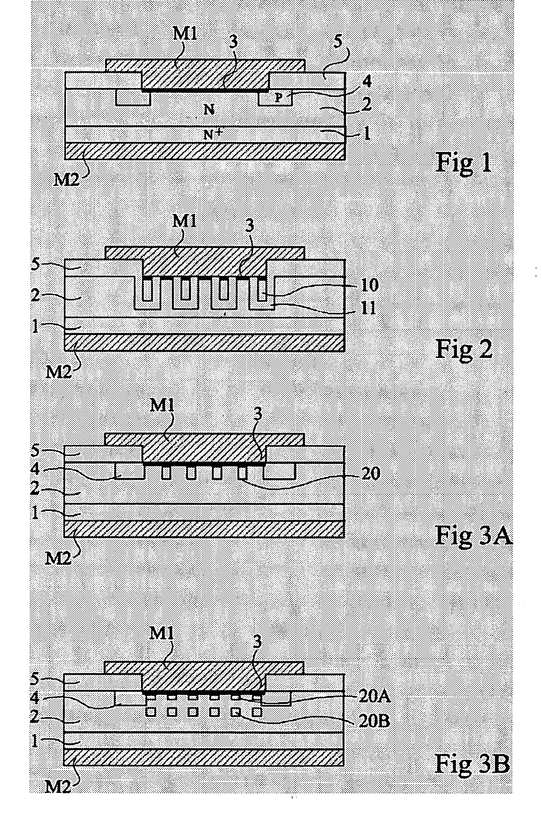

De façon classique, de telles diodes Schottky sont réalisées de sorte que leur jonction/barrière est parallèle au plan principal de la plaquette dans laquelle elles sont formées, comme l'illustre la figure 1. On parle de jonction horizontale. La diode est formée à partir d'un substrat de silicium 1 fortement dopé d'un premier type de conductivité, ici le type N, sur lequel est formée une couche épitaxiée plus faiblement dopée 2. Du côté de la face supérieure est formée une barrière Schottky entre un métal, ou plus souvent un siliciure métallique 3, et la couche épitaxiée 2. Pour améliorer la tenue en tension, la périphérie de la jonction Schottky est par exemple entourée d'un anneau 4 de type P. Une couche d'isolement 5 est destinée à assurer les isolements nécessaires. Une métallisation M1 est formée du côté de la face supérieure, et une métallisation M2 est formée du côté de la face inférieure.

Dans une telle diode Schottky, à l'état conducteur, le courant circule de la face supérieure à la face inférieure d'une puce de silicium. On notera toutefois que la barrière ou jonction Schottky est horizontale (parallèle au plan des faces principales de la diode).

Plusieurs améliorations ont été apportées aux diodes Schottky, notamment pour réduire leur chute de tension en direct, en prévoyant des moyens pour assurer une déplétion de la zone correspondant au substrat au voisinage de la jonction Schottky quand la tension inverse augmente. Des exemples de telles structures sont illustrés en figures 2, 3A et 3B.

En figure 2, des doigts conducteurs 10 entourés d'un isolant 11 pénètrent dans le substrat à intervalles réguliers à partir de la zone de contact Schottky, ces doigts étant en contact avec la métallisation supérieure. Une telle structure de diode Schottky, ou diode Schottky à barrière MOS, est couramment désignée par l'abréviation TMBS (de l'anglais Trench MOS Barrier Schottky).

En figure 3A, des doigts 20 de silicium de type P en contact avec la métallisation supérieure pénètrent dans le substrat. Une telle diode ou diode Schottky-bipolaire est couramment appelée diode JBS (de l'anglais Junction Barrier Schottky).

La figure 3B représente une variante, à îlots flottants de la structure de diode Schottky-bipolaire de la figure 3A, dans laquelle les doigts 20 sont décomposés en doigts disjoints 20a-20b couplés entre eux par effet capacitif.

Dans toutes ces structures connues, la jonction ou barrière Schottky, éventuellement réalisée en plusieurs éléments, est toujours horizontale pour chacun des éléments considérés.

Le document EP-A-0 271 346 décrit un dispositif comprenant une junction Schottky verticale.

Par ailleurs, la demanderesse a décrit dans la demande de brevet français non publiée 03/50985 du 5 décembre 2003, inventeur Jean-Luc Morand, des composants semiconducteurs à jonction active verticale.

Les figures 4 et 5 ci-jointes reprennent les figures 3 et 4 de cette demande de brevet.

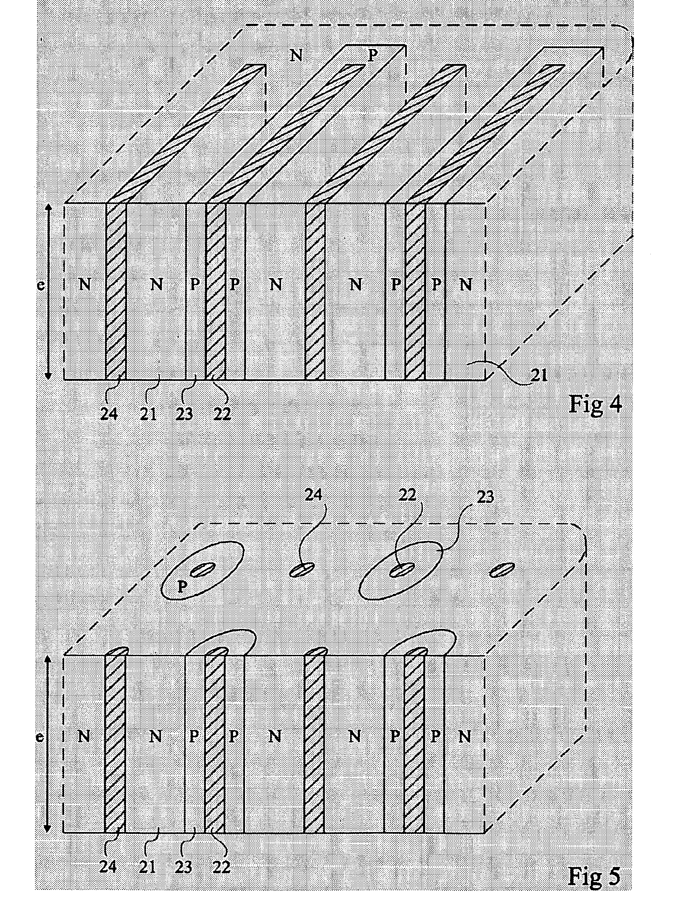

Ces figures 4 et 5 sont des vues en coupe et en perspective représentant un ensemble de cellules de diodes à jonction verticale, sans métallisation. Une cellule de diode est constituée d'une interface entre des régions N et P 21 et 23, la région 23 étant en contact avec une métallisation 22, et la région 21 avec une métallisation 24. Toutes les métallisations de même type que la métallisation 22 sont reliées à une même métallisation d'anode, et toutes les métallisations de même type que la métallisation 24 sont reliées à une même métallisation de cathode. De préférence, les métallisations d'anode et de cathode sont disposées sur des faces opposées du composant. Un avantage de cette structure pour une diode de puissance est que les jonctions s'étendent sur toute l'épaisseur de la diode et donc que la surface de jonction peut être plus importante que dans le cas de diodes à jonction horizontale, dans lesquelles la surface de jonction est limitée à la surface de la puce de silicium. Dans le mode de réalisation de la figure 4, les diverses diodes sont disposées en bandes parallèles. Dans le mode de réalisation de la figure 5, les diverses diodes ont des structures circulaires. D'autres topologies peuvent être adoptées du moment que les diodes ont des jonctions verticales.

Les structures des figures 4 et 5 peuvent facilement être adaptées à la réalisation d'une diode Schottky à jonction (ou barrière) verticale en remplaçant la région de type P 23 par un métal, un siliciure métallique, ou autre matériau formant une barrière Schottky avec une région N.

Un objet de la présente invention est de prévoir de nouvelles structures de diodes TMBS ou JBS à jonction (barrière) verticale.

Pour atteindre cet objet, la présente invention prévoit une diode Schottky à barrière verticale s'étendant perpendiculairement à la surface d'une puce semiconductrice comprenant un conducteur métallique central vertical en contact d'une part avec le substrat de la puce semiconductrice avec interposition d'une interface formant barrière Schottky, d'autre part avec des doigts conducteurs s'étendant radialement.

Selon un mode de réalisation de la présente invention, la diode est de type TMBS, et les doigts conducteurs s'étendant radialement sont isolés à leur périphérie.

Selon un mode de réalisation de la présente invention, la diode est de type Schottky-bipolaire, et les doigts s'étendant radialement correspondent à des régions semiconductrices fortement dopées de type P.

Selon un mode de réalisation de la présente invention, lesdits doigts sont séparés en fragments discontinus.

Selon un mode de réalisation de la présente invention, la forme en vue de dessus desdits doigts est optimisée par le choix d'un masque adapté.

Selon un mode de réalisation de la présente invention, l'extrémité desdits doigts est arrondie.

Selon un mode de réalisation de la présente invention, l'extrémité desdits doigts est plus large et plus étroite que la partie desdits doigts en contact avec le conducteur central.

Dans l'application à une diode TMBS ou JBS, on obtient un avantage supplémentaire par rapport à l'avantage de l'augmentation de la surface de jonction par rapport à la surface d'une puce. En effet, on montrera que, selon un avantage de l'invention, on peut réaliser des topologies spécifiques permettant d'améliorer les caractéristiques de réduction de la chute de tension en direct, d'augmentation de la tenue en tension inverse et de réduction du courant de fuite en inverse.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1, 2, 3A et 3B, déjà décrites, sont des vues en coupe illustrant divers types de diodes Schottky classiques ;
les figures 4 et 5 représentent des diodes bipolaires à jonction verticale telles que décrites dans la demande de brevet français non publiée 03/50985 ;
la figure 6A est une vue de dessus d'une diode Schottky de type TMBS selon un mode de réalisation de la présente invention ;
la figure 6B est une vue en coupe selon la ligne A-A de la figure 6A ;
la figure 6C est une vue en coupe selon la ligne B-B de la figure 6A ;
les figures 7A à 7I illustrent des étapes successives de fabrication d'une diode de type TMBS selon la présente invention ;
la figure 8 est une vue de dessus illustrant des variantes de diodes TMBS selon la présente invention ;
la figure 9A est une vue de dessus illustrant une diode Schottky-bipolaire à îlots flottants selon un mode de réalisation de la présente invention ;
la figure 9B est une coupe selon la ligne A-A de la figure 9A ;
la figure 9C est une coupe selon la ligne B-B de la figure 9A ; et
la figure 10 est une vue de dessus illustrant une variante de réalisation de diode Schottky bipolaire selon la présente invention.

Par souci de clarté, de mêmes éléments ont été désignés par de mêmes références aux différentes figures et, de plus, comme cela est habituel dans la représentation des composants intégrés, les diverses figures ne sont pas tracées à l'échelle.

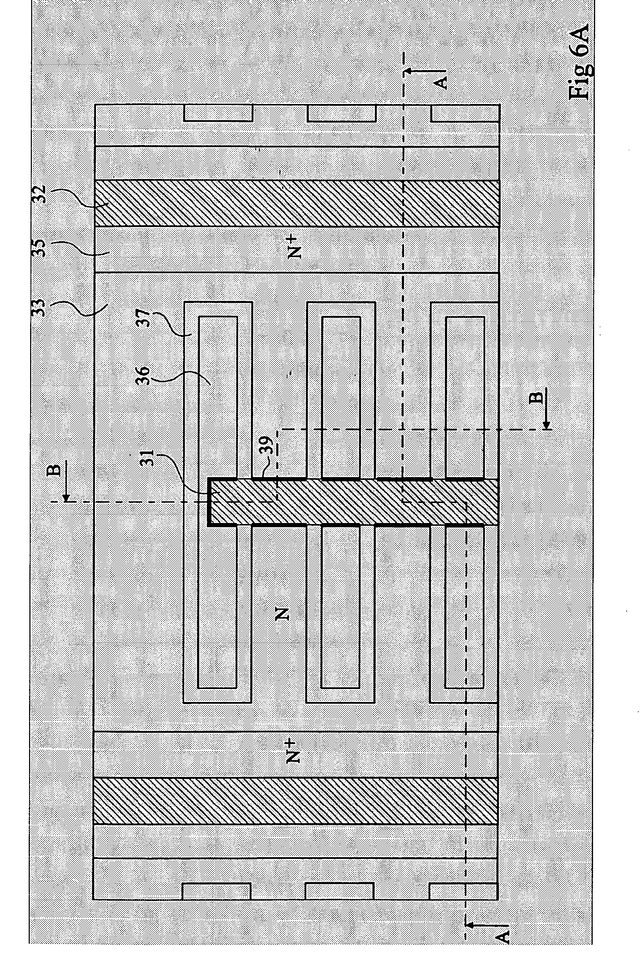

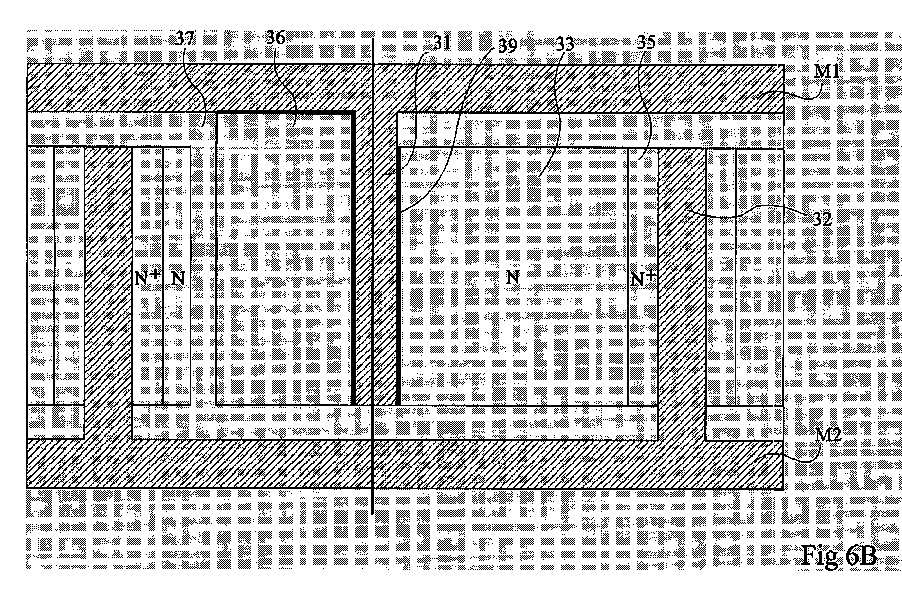

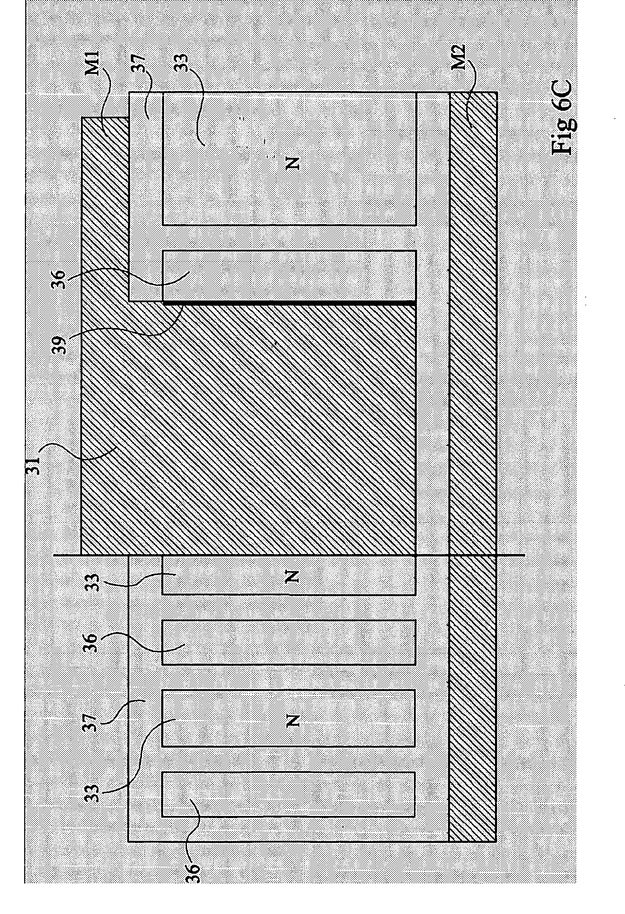

En se référant aux figures 6A, 6B et 6C qui sont respectivement une vue de dessus, une vue en coupe selon la ligne A-A, et une vue en coupe selon la ligne B-B, on va décrire un mode de réalisation d'une diode Schottky TMBS selon la présente invention. Ces figures représentent deux cellules de diodes de part et d'autre d'une anode. On comprendra que ce motif peut se répéter par symétrie. On comprendra également que la topologie illustrée n'est qu'un exemple de topologie possible. Notamment, en se référant aux figures 4 et 5, on notera qu'on peut passer de topologies de type "en bande" à des topologies de type "radial". D'ailleurs, dans la présente description et dans les revendications ci-après, on désignera par le terme "radial" des éléments ou doigts s'étendant sensiblement orthogonalement à des électrodes principales verticales.

La diode Schottky de type TMBS des figures 6A, 6B et 6C comprend une anode 31 et une cathode 32. Cette anode et cette cathode sont constituées d'un conducteur, par exemple un métal s'étendant sur toute l'épaisseur d'une plaquette de silicium 33 faiblement dopée de type N. Une région fortement dopée de type N 35 est adjacente à l'électrode de cathode 32. Des doigts conducteurs 36, par exemple en silicium polycristallin fortement dopé, s'étendent radialement à partir du conducteur d'anode 31 et sont entourés d'une couche isolante 37. Un métal, un siliciure métallique ou analogue formant une jonction ou barrière Schottky avec le silicium faiblement dopé de type N, par exemple un siliciure de nickel 39, est disposé à l'interface entre l'électrode d'anode 31 et le substrat 33. On obtient bien ainsi une structure de diode Schottky de type TMBS retournée par rapport aux structures habituelles, c'est-à-dire que la vue de dessus correspond sensiblement à la vue en coupe d'une diode TMBS habituelle telle qu'illustrée en figure 2.

Les vues en coupe des figures 6B et 6C illustrent, en plus des éléments déjà décrits, une métallisation supérieure M1 en contact avec les doigts d'anode 31 et une métallisation inférieure M2 en contact avec les doigts de cathode 32. Une couche isolante non référencée est insérée aux emplacements où il faut éviter un contact.

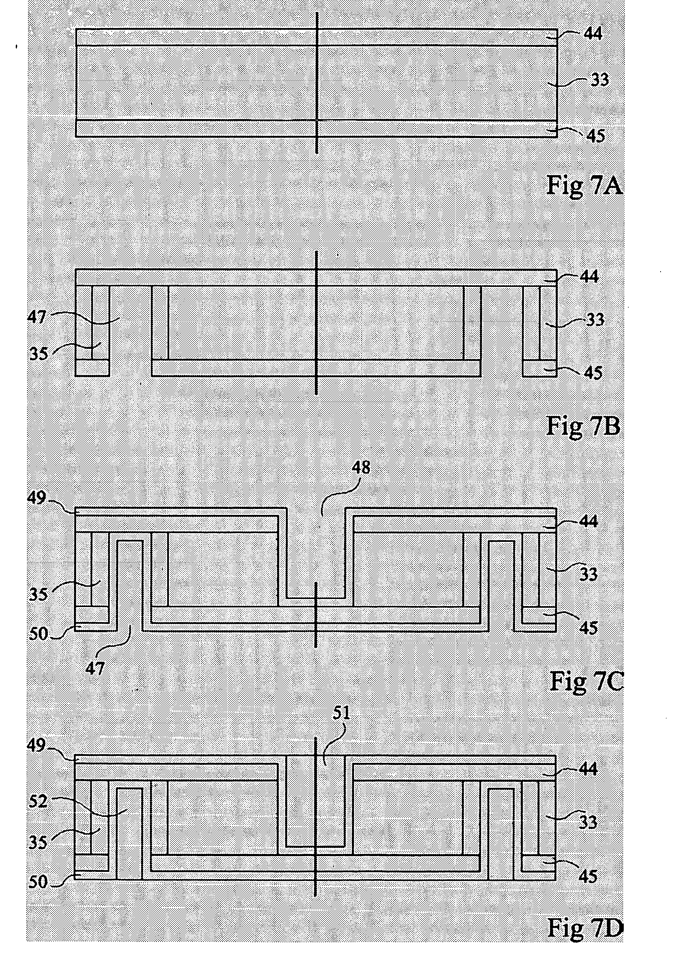

Les figures 7A à 7K sont des vues en coupe selon la ligne A-A de la figure 6A illustrant des étapes successives d'un mode de fabrication possible d'un dispositif selon la présente invention.

Dans ces figures, le trait noir central indique un changement de plan dans la coupe A-A. De plus, seules certaines étapes principales sont décrites, et non pas les détails évidents pour l'homme de l'art, comme certaines étapes de masquage, de planarisation, de recuit...

On part d'une plaquette de silicium 33 revêtue sur ses faces externes de couches d'oxyde supérieure 44 et inférieure 45 (figure 7A).

Ensuite, on ouvre complètement la plaquette à partir de sa face inférieure par photogravure ou par tout autre moyen choisi pour former des ouvertures 47 aux emplacements où doivent être formées les cathodes. Une diffusion est ensuite réalisée pour obtenir des couches de cathode 35 fortement dopées de type N (figure 7B) .

Ensuite, on ouvre complètement la plaquette à partir de sa face supérieure par photogravure ou par tout autre moyen choisi pour former des ouvertures 48 aux emplacements où doivent être formées les anodes. On dépose une couche de protection, par exemple une couche de nitrure de silicium, désignée par la référence 49 du côté de la face supérieure et par la référence 50 du côté de la face inférieure (figure 7C).

Ensuite, on procède à un remplissage et à une planarisation des ouvertures formées dans la plaquette, par exemple par de l'oxyde de silicium désigné par les références 51 côté anode et 52 côté cathode (figure 7D).

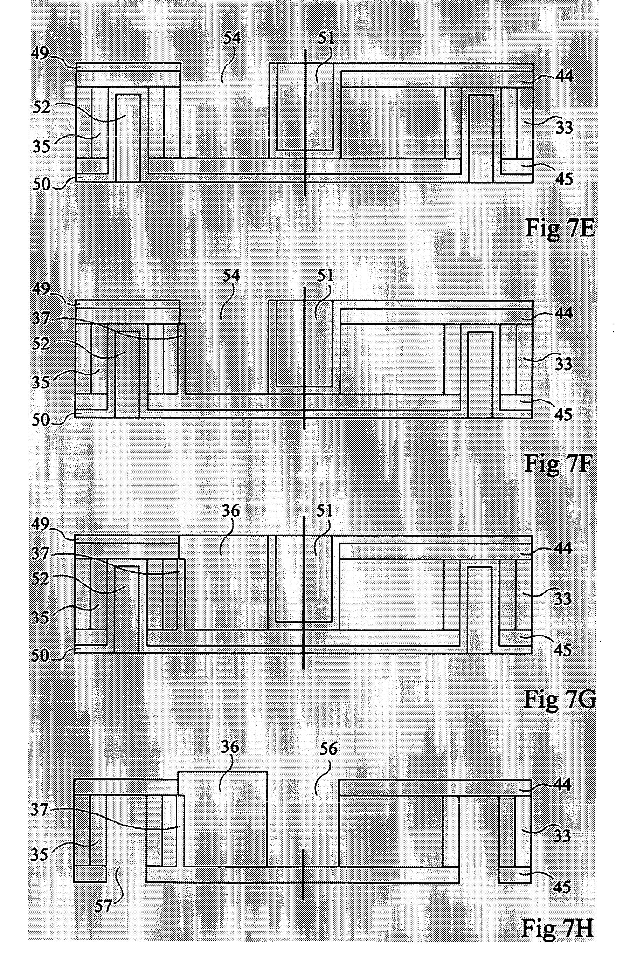

Ensuite, on procède à une gravure à partir de la face supérieure aux emplacements où l'on veut former les doigts isolés transverses désignés par la référence 36 en figure 6. Cette ouverture est désignée par la référence 54 (figure 7E).

Ensuite, on procède à une oxydation pour former la couche d'oxyde 37 d'isolement des doigts de silicium polycristallin 36 (figure 7F).

Ensuite, on procède au remplissage et à la planarisation des ouvertures 54 par du silicium polycristallin 36 (figure 7G) .

Ensuite, on procède successivement à des étapes de désoxydation humide puis de gravure humide du nitrure de silicium, pour dégager des ouvertures d'anode désignées par la référence 56 et des ouvertures de cathode désignées par la référence 57 (figure 7H).

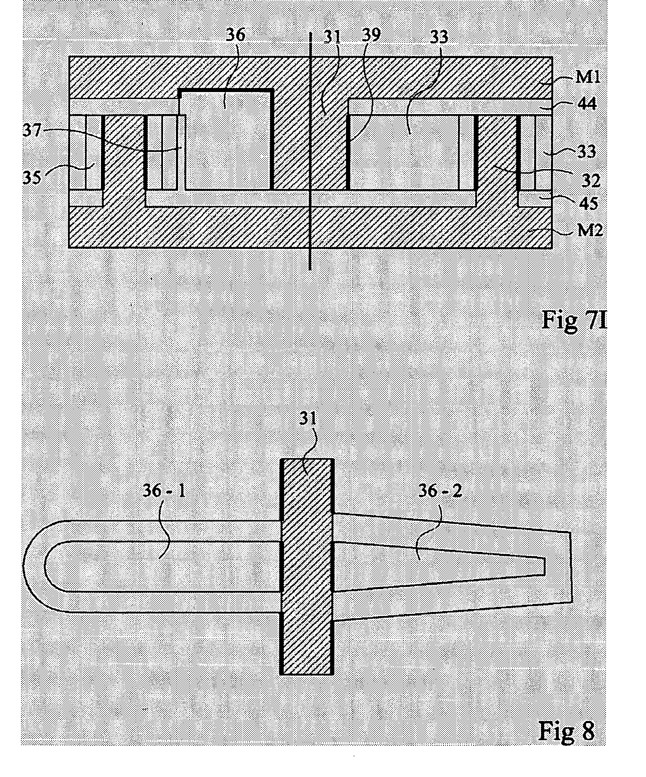

Ensuite, on dépose un métal, on recuit pour obtenir un siliciure destiné à former la barrière Schottky 39 et on élimine le métal en excès. On notera que ce siliciure peut être formé sans inconvénient au niveau de la cathode, où il n'aura pas d'effet Schottky, mais simplement un rôle de contact. On procède au remplissage par un conducteur métallique pour former les anodes et les cathodes verticales. Et, si cela ne résulte pas de l'étape précédente, on dépose et on grave des métallisations supérieure et inférieure M1 et M2. On obtient ainsi la structure de la figure 7I qui correspond à la structure déjà illustrée et décrite en relation avec la figure 6B.

Par rapport à une diode Schottky TMBS à jonction horizontale selon l'art antérieur, une diode Schottky TMBS à jonction/barrière verticale selon l'invention présente l'avantage indiqué précédemment selon lequel la surface de jonction augmente pour une surface de puce donnée.

En outre et, comme l'homme de l'art le comprendra en se référant à la description précédente d'un procédé possible de fabrication d'une structure selon la présente invention, une diode Schottky TMBS à jonction/barrière verticale selon l'invention présente l'avantage que l'on peut donner simplement aux doigts de création d'un effet de champ toute forme choisie, éventuellement complexe, puisque la forme de ces doigts résulte d'une opération de masquage et de gravure, et non d'une opération d'implantation/diffusion.

On a représenté en vue de dessus en figure 8, à gauche et à droite d'un conducteur vertical d'anode 31, deux formes possibles de doigts 36. Le doigt de gauche 36-1 a une forme arrondie à son extrémité la plus éloignée de l'anode. Cette forme favorise la tenue en tension. En effet, il est connu que les claquages sont susceptibles de survenir essentiellement dans les zones à forte courbure d'une structure. Du côté droit de la figure, on a représenté un doigt 36-2 plus large au niveau de l'anode qu'au niveau de son extrémité éloignée. Ceci favorise une déplétion plus importante des zones intermédiaires entre les doigts au niveau de l'anode qu'à distance de l'anode. Ceci aussi entraîne une amélioration de la tenue en tension du dispositif, et surtout une réduction du courant de fuite.

Un autre avantage de la structure selon la présente invention réside dans le fait qu'une mise en série ou en parallèle des diodes Schottky des cellules élémentaires est particulièrement simple à réaliser.

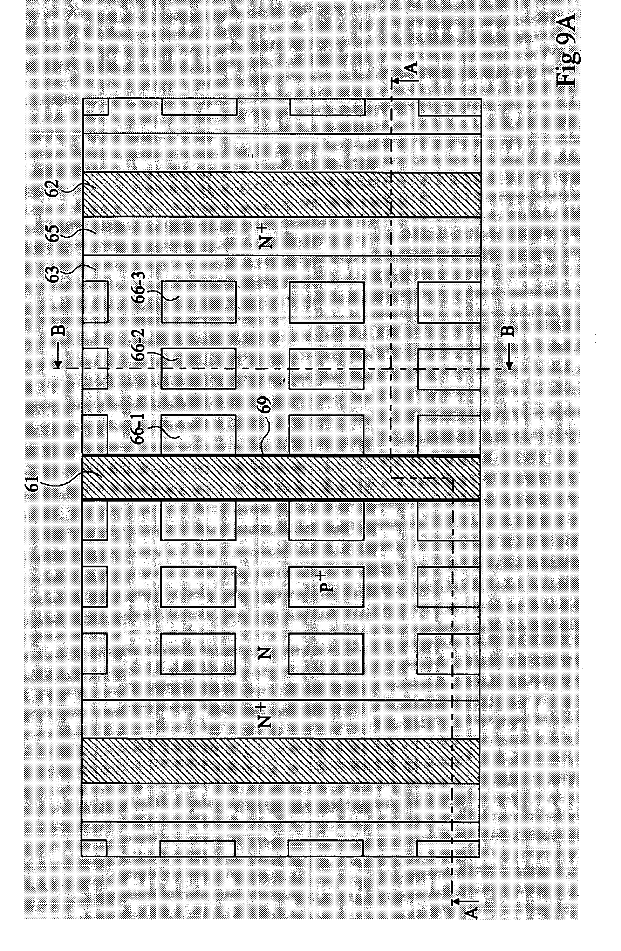

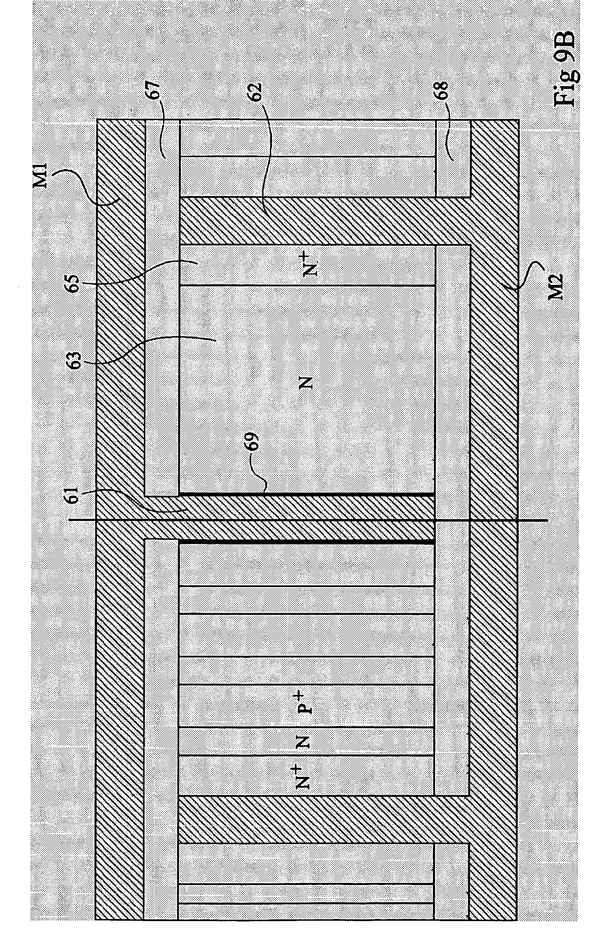

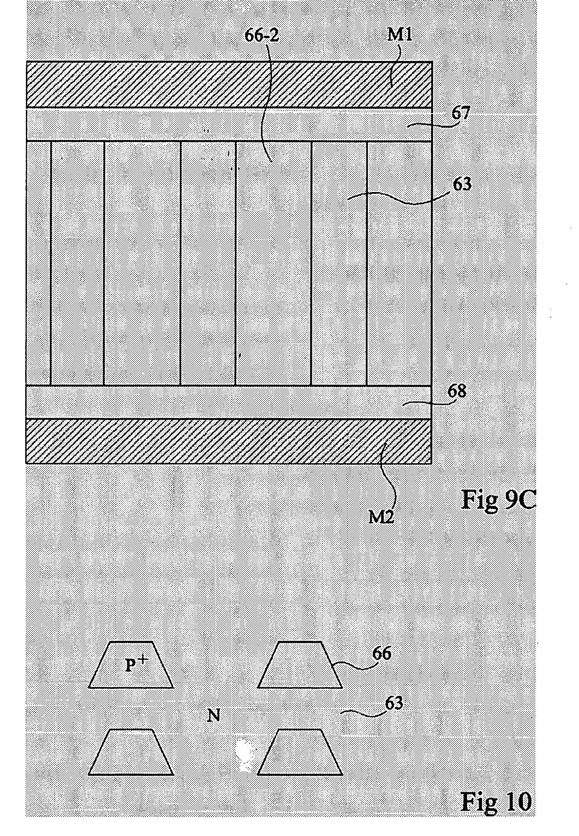

Les figures 9A, 9B, 9C représentent respectivement en vue de dessus et en vues en coupe selon la ligne A-A et selon la ligne B-B, un mode de réalisation d'une diode Schottky de type Schottky-bipolaire à îlots flottants.

On retrouve entre une métallisation verticale d'anode 61 perpendiculaire à la tranche et une métallisation verticale de cathode 62 perpendiculaire à la tranche un substrat de silicium faiblement dopé de type N 63. Une couche fortement dopée de type N 65, destinée à obtenir un contact ohmique, est en contact avec la métallisation de cathode 62. Des doigts de silicium polycristallin dopé de type P s'étendent radialement à partir de l'électrode d'anode 61. Ces doigts pourraient être continus. On a représenté dans la figure une structure à îlots flottants comprenant des doigts 66 constitués chacun de trois parties discontinues 66-1, 66-2 et 66-3. Les références 67 et 68 désignent un isolant, par exemple un oxyde. Un métal, siliciure ou autre élément destiné à assurer un contact Schottky 69 est interposé entre le conducteur d'anode 61 et le substrat de silicium faiblement dopé de type N 63.

On obtient bien ainsi une structure qui, en vue de dessus, correspond sensiblement à la vue en coupe du dispositif de l'art antérieur représenté en figure 3B. Les figures 9A-9C ne seront pas décrites plus en détail, étant donné qu'elles se comprennent bien à la lumière des explications données précédemment en relation avec la diode Schottky de type TMBS à jonction verticale.

L'homme de l'art pourra réaliser une structure telle que celle des figures 9A-9C par un procédé similaire à celui décrit précédemment. La différence essentielle entre ce procédé et celui décrit précédemment résidant dans le fait que le remplissage des tranchées décrit en relation avec les figures 7E à 7G n'est pas précédé d'une étape d'oxydation mais d'une étape de diffusion de dopant. Ainsi, les îlots seront constitués d'une région de silicium monocristallin dopé à la périphérie d'un coeur en silicium polycristallin.

Une telle diode Schottky-bipolaire à barrière verticale présente par rapport à une diode Schottky-bipolaire classique des avantages similaires à ceux indiqués précédemment pour une diode Schottky TMBS. Dans le cas d'une diode Schottky-bipolaire à îlots flottants, on soulignera que les procédés de fabrication classiques sont généralement complexes. A nouveau, on peut donner aux doigts radiaux, ou aux îlots radiaux, des formes soigneusement choisies, par exemple telle que celle illustrée en vue de dessus en figure 10.

On soulignera que les performances d'une diode Schottky-bipolaire à îlots flottants dépendent notamment du nombre d'îlots flottants. Pour les structures classiques, le procédé de fabrication est complexe pour chaque niveau d'îlots flottants (épitaxie, masquage, implantation) et doit être répété plusieurs fois. Selon l'invention quel que soit le nombre de niveaux d'îlots flottants, ils sont formés par les mêmes étapes.

De même, selon l'art antérieur, la forme des doigts d'une diode TMBS ou des îlots flottants d'une diode Schottky-bipolaire dépend d'enchaînements d'opérations d'épitaxie, masquage et implantation, alors que selon l'invention elle dépend seulement d'un dessin de masque, ce qui simplifie les opérations et laisse au concepteur une grande liberté de choix de formes.

## Revendications

1. Diode Schottky à barrière verticale s'étendant perpendiculairement à la surface d'une puce semiconductrice comprenant un conducteur métallique central (31) vertical en contact, d'une part avec le substrat (33) de la puce semiconductrice, sur toute la hauteur dudit substrat, avec interposition d'une interface formant barrière Schottky (39),et d'autre part avec des doigts conducteurs (36) s'étendant radialement, sur toute la hauteur desdits doigts conducteurs.

2. Diode Schottky selon la revendication 1, de type TMBS, dans laquelle les doigts conducteurs s'étendant radialement sont isolés à leur périphérie.

3. Diode Schottky selon la revendication 1, de type Schottky-bipolaire, dans laquelle les doigts (66) s'étendant radialement sont constitués de régions semiconductrices fortement dopées de type P.

4. Diode Schottky selon la revendication 3, dans laquelle chacun desdits doigts est séparé en fragments discontinus (66-1, 66-2, 66-3).

5. Diode Schottky selon l'une quelconque des revendications 1 à 4, dans laquelle la forme en vue de dessus desdits doigts est optimisée par le choix d'un masque adapté de définition desdits doigts.

6. Diode Schottky selon la revendication 5, dans laquelle l'extrémité desdits doigts est arrondie.

7. Diode Schottky selon la revendication 5, dans laquelle l'extrémité desdits doigts est plus étroite que la partie desdits doigts en contact avec le conducteur central.

## Claims

1. A Schottky diode with a vertical barrier extending perpendicularly to the surface of a semiconductor chip comprising a vertical central metal conductor (31) in contact, on the one hand with the substrate (33) of the semiconductor chip on the entire height of said substrate, with an interposed interface forming a Schottky barrier (39), and on the other hand with conductive fingers (36) radially-extending on the entire height of said conductive fingers.

2. The Schottky diode of claim 1, of TMBS type, wherein the radially-extending conductive fingers are insulated at their periphery.

3. The Schottky diode of claim 1, of Schottky-bipolar type, wherein the radially-extending fingers (66) are made of heavily-doped P-type semiconductor regions.

4. The Schottky diode of claim 3, wherein each of said fingers is separated in discontinuous fragments (66-1, 66-2, 66-3) .

5. The Schottky diode of claim 1, wherein the shape in top view of said fingers is optimized by the selection of an adapted mask for defining said fingers.

6. The Schottky diode of claim 5, wherein the end of said fingers is rounded.

7. The Schottky diode of claim 5, wherein the end of said fingers is narrower than the portion of said fingers in contact with the central conductor.

## Patentansprüche

1. Eine Schottky-Diode mit einer vertikalen Barriere, die sich rechtwinklig zu der Oberfläche von einem Halbleiter-Chip erstreckt, der einen vertikalen zentralen Metallleiter (31) aufweist, der sich in Kontakt befindet, einerseits mit dem Substrat (33) von dem Halbleiter-Chip auf der gesamten Höhe von dem Substrat, mit einem dazwischen liegenden Interface, das eine Schottky-Barriere (39) bildet und andererseits mit leitenden Fingern (36), die sich radial erstrecken, auf der gesamten Höhe von den leitenden Fingern.

2. Schottky-Diode nach Anspruch 1, vom TMBS-Typ, wobei die sich radial erstreckenden leitenden Finger an ihrer Peripherie bzw. am Umfang isoliert sind.

3. Schottky-Diode nach Anspruch 1, vom Schottky-bipolaren Typ, wobei die sich radial erstreckenden Finger (66) aus stark dotierten Halbleiter-Regionen vom P-Typ hergestellt sind.

4. Schottky-Diode nach Anspruch 3, wobei jeder von den Fingern in diskontinuierliche Fragmente (66-1, 66-2, 66-3) separiert ist.

5. Schottky-Diode nach Anspruch 1, wobei die Form in der Draufsicht auf die Finger optimiert ist durch die Wahl von einer adaptierten Maske zum Definieren der Finger.

6. Schottky-Diode nach Anspruch 5, wobei das Ende von den Fingern gerundet ist.

7. Schottky-Diode nach Anspruch 5, wobei das Ende von den Fingern enger ist, als der Teil von den Fingern in Kontakt mit dem zentralen Leiter.
